(19) Europäisches Patentamt / European Patent Office / Office européen des brevets

(11) **EP 4 745 714 A1**

(12) **EUROPEAN PATENT APPLICATION**

(43) Date of publication:
20.05.2026 Bulletin 2026/21

(21) Application number: 25209230.9

(22) Date of filing: 16.10.2025

(51) International Patent Classification (IPC):
**G06F 1/16** (2006.01)    **G02F 1/1333** (2006.01)
**G02F 1/1339** (2006.01)

(52) Cooperative Patent Classification (CPC):
**G06F 1/1607; G02F 1/133308; G02F 1/133311;
G02F 1/133314; G06F 1/1637; G06F 1/1656;**
G02F 2202/28; G06F 2200/1612

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 13.11.2024 JP 2024198449

(71) Applicant: **Panasonic Intellectual Property
Management Co., Ltd.
Kadoma-shi, Osaka 571-0057 (JP)**

(72) Inventor: **MASAKI, Ryota
Osaka, 571-0057 (JP)**

(74) Representative: **Eisenführ Speiser
Patentanwälte Rechtsanwälte PartGmbB
Postfach 10 60 78
28060 Bremen (DE)**

(54) **DISPLAY DEVICE**

(57) A display device (100) for use in an aircraft (1) includes: a display module (101) that includes a display panel (120) that displays an image on a front surface of the display panel (120); a housing (150) that faces a back surface (105) of the display module (101) and supports the display module (101); a first adhesive component (210); and a second adhesive component (250). The first adhesive component (210) connects a peripheral portion (106) of the back surface (105) and the housing (150). The second adhesive component (250) connects a central portion (108) and the housing (150). The central portion (108) is a region located inward of the peripheral portion (106) of the back surface (105). The first adhesive component (210) and the second adhesive component (250) are spaced apart from each other along an entire perimeter of the second adhesive component (250) when viewed in a front-and-back direction.

FIG. 4

## Description

### Field

The present disclosure relates to a display device.

### Background

Patent Literature (PTL) 1 discloses an electronic device that includes a flexible display, a housing, and a back plate. The flexible display includes a first surface that includes a display screen and a second surface that is disposed on a side opposite of the first surface. The back plate is disposed between the flexible display and a rear wall of the housing. The back plate is attached to the second surface of the flexible display by adhesive, such as double-sided tape, for example, or another method, and is fixed to the rear wall of the housing. The back plate includes a frame and a beam. The frame is provided in a rectangular frame shape that includes four sides, and supports a peripheral portion of the flexible display. The beam extends between two long sides of the frame, and supports a central portion of the flexible display.

### Citation List

### Patent Literature

PTL 1: Japanese Unexamined Patent Application Publication No. 2012-213119

### Summary

### Technical Problem

In the above-mentioned, conventional electronic device, a wide and continuous area that includes the peripheral portion and the central portion of the flexible display is attached to the back plate by double-sided tape or the like. Accordingly, for example, a relatively large surface area of double-sided tape that corresponds to the size of the flexible display is necessary. Furthermore, when double-sided tape that corresponds to the peripheral portion of the flexible display and double-sided tape that corresponds to the central portion are provided separate from each other, the pieces of double-sided tape become prone to peeling that occurs due to the dimensional tolerances of the thickness and the like of the two pieces of double-sided tape at a boundary between the two pieces of double-sided tape. In particular, since unpredictable and significant swaying and the like tends to occur in an aircraft, in a display device for use in an aircraft, it may be desirable that resistance to vibration, impact, or the like is high.

The present disclosure has been conceived by the inventor as a novel approach for solving the above-mentioned problem, and provides a display device with improved reliability.

### Solution to Problem

A display device according to one aspect of the present disclosure is a display device for use in an aircraft, and the display device includes: a display module that includes a display panel that displays an image on a front surface of the display panel; a housing that faces a back surface of the display module and supports the display module; a first adhesive component that connects a peripheral portion of the back surface and the housing; and a second adhesive component that connects the housing and a central portion of the back surface, the central portion being a region located inward of the peripheral portion of the back surface, wherein the first adhesive component and the second adhesive component are spaced apart from each other along an entire perimeter of the second adhesive component when viewed in a front-and-back direction.

### Advantageous Effects

The present disclosure can provide a display device with improved reliability.

### Brief Description of Drawings

[FIG. 1]

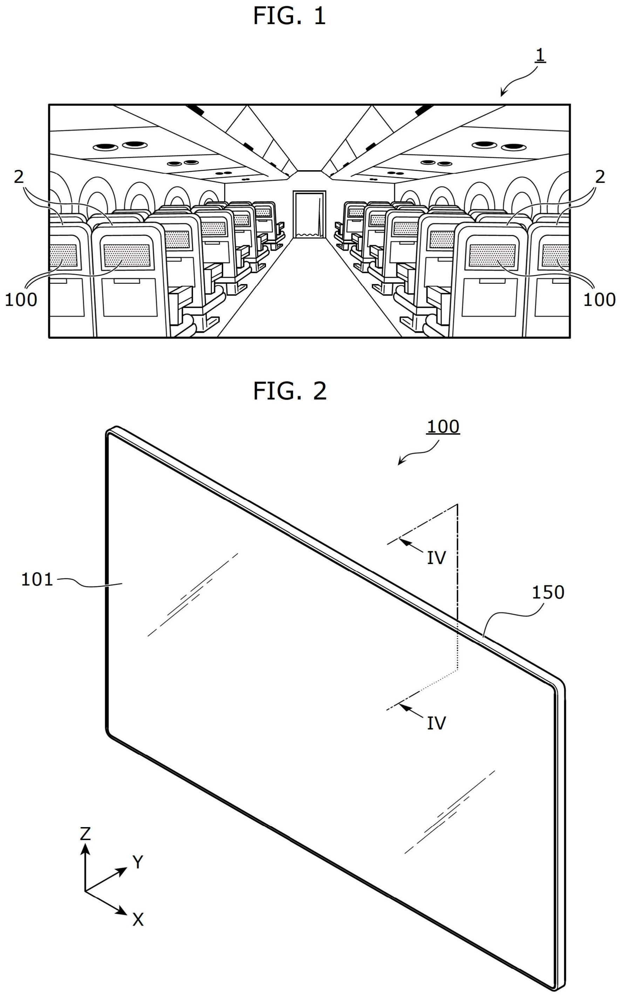

FIG. 1 is a drawing illustrating an example of an arrangement of a plurality of display devices according to an embodiment.

[FIG. 2]

FIG. 2 is a perspective view illustrating an appearance of a display device according to the embodiment.

[FIG. 3]

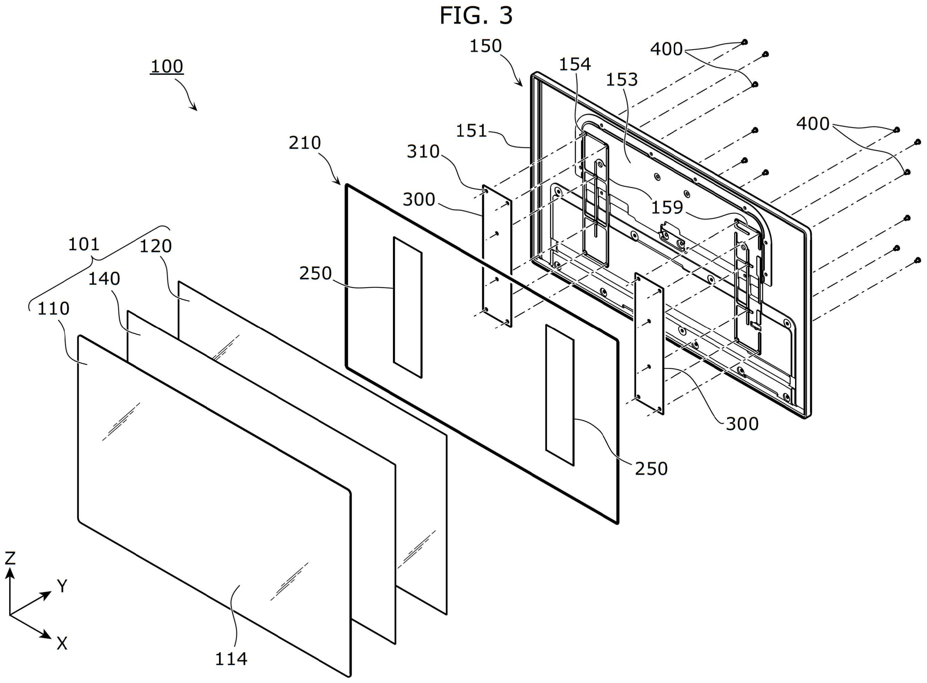

FIG. 3 is an exploded perspective view of the display device according to the embodiment.

[FIG. 4]

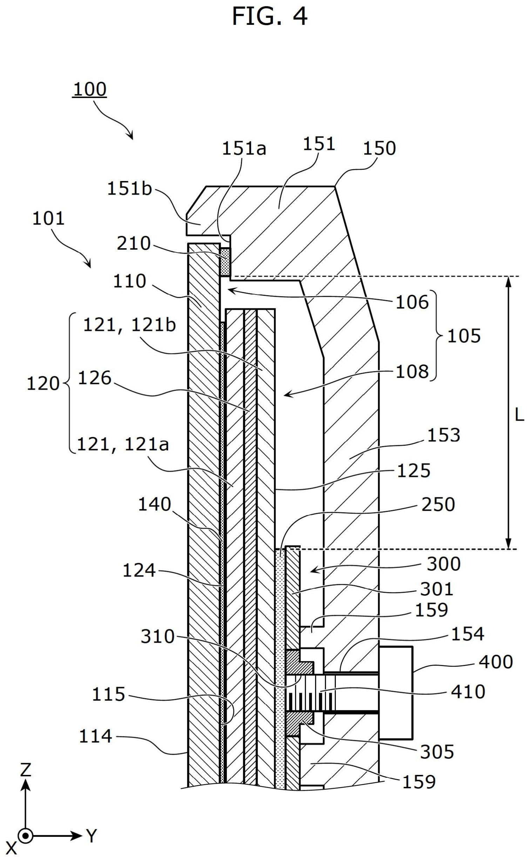

FIG. 4 is a cross-sectional view of an assembly structure for a housing of a display module according to the embodiment.

[FIG. 5A]

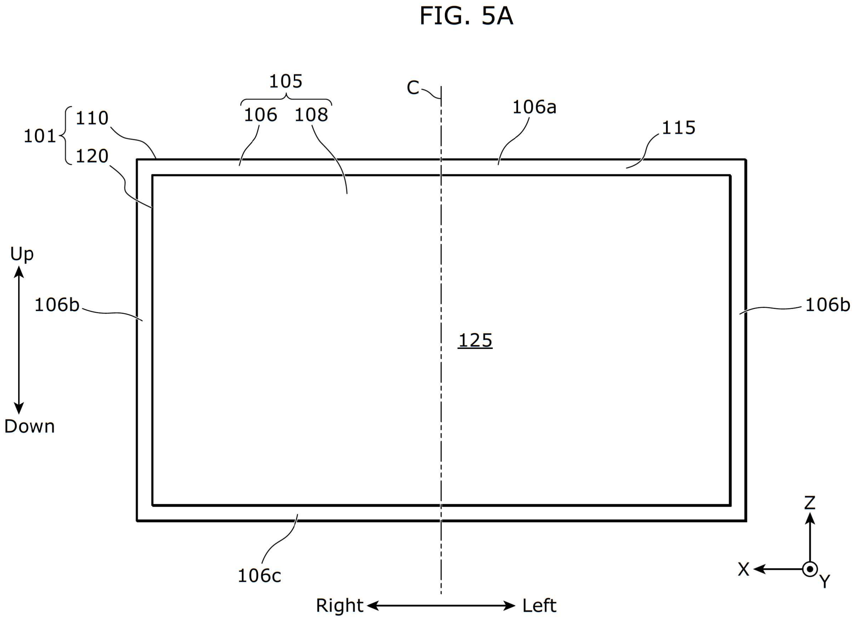

FIG. 5A is a rear view of a configuration of a back surface of the display module according to the embodiment.

[FIG. 5B]

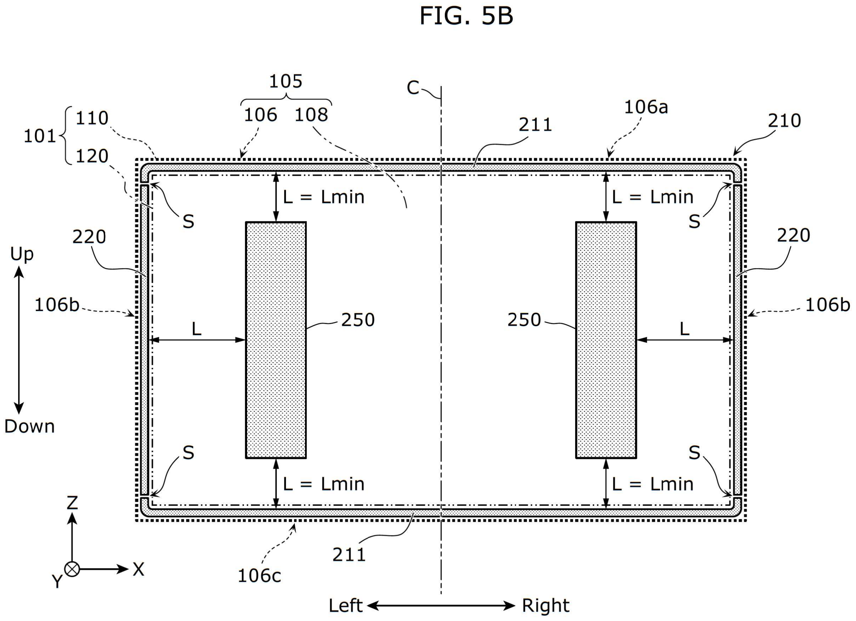

FIG. 5B is a front view of an example of a layout of a first adhesive component and second adhesive components according to the embodiment.

[FIG. 6]

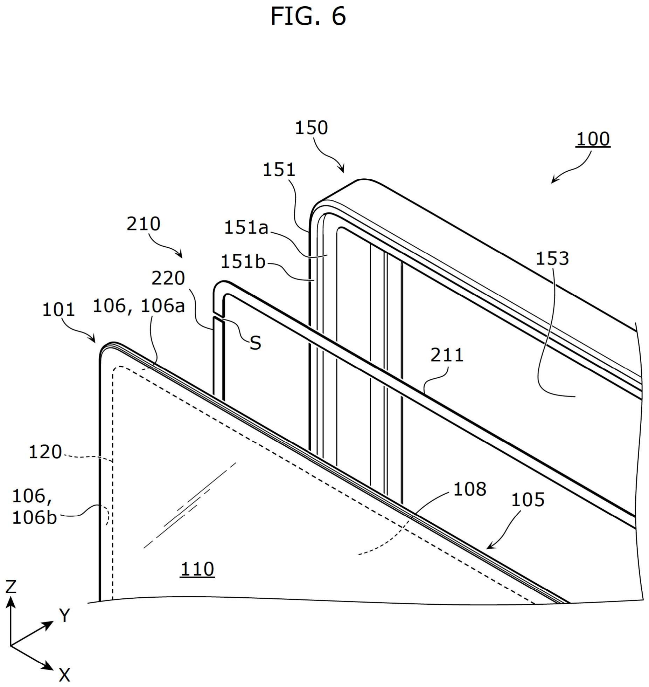

FIG. 6 is an enlarged, exploded perspective view illustrating a portion of the first adhesive component according to the embodiment.

[FIG. 7]

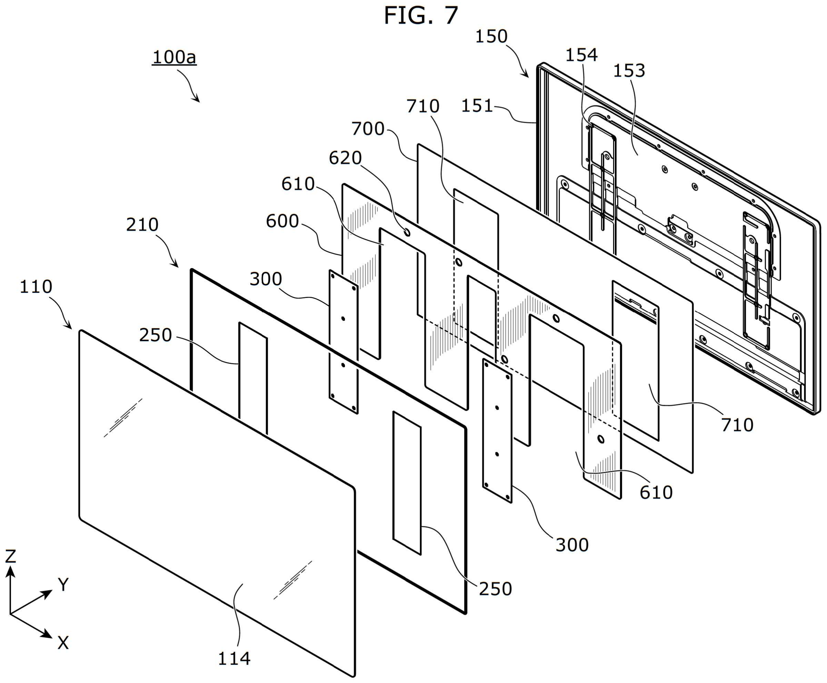

FIG. 7 is an exploded perspective view of a display device according to a variation of the embodiment.

[FIG. 8]

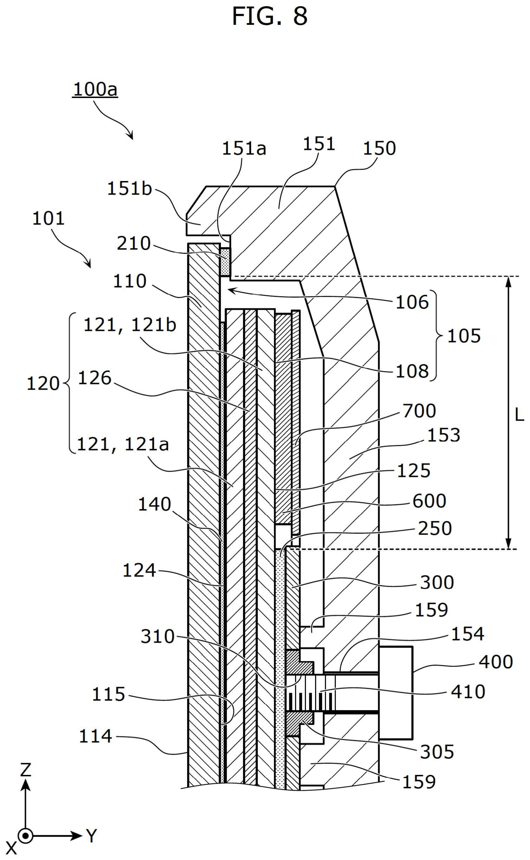

FIG. 8 is a cross-sectional view of an assembly structure for a housing of a display module according to the variation of the embodiment.

**Description of Embodiment**

A display device according to a first aspect of the present disclosure is a display device for use in an aircraft, and the display device includes: a display module that includes a display panel that displays an image on a front surface of the display panel; a housing that faces a back surface of the display module and supports the display module; a first adhesive component that connects a peripheral portion of the back surface and the housing; and a second adhesive component that connects the housing and a central portion of the back surface, the central portion being a region located inward of the peripheral portion of the back surface, in which the first adhesive component and the second adhesive component are spaced apart from each other along an entire perimeter of the second adhesive component when viewed in a front-and-back direction.

Accordingly, in the display device according to the above-mentioned first aspect, by connecting the peripheral portion of the back surface of the display module and the housing by the first adhesive component, foreign substances, such as dust, liquid, and the like are prevented from entering the interior of the display module from the peripheral portion. Furthermore, by connecting the central portion of the back surface of the display module and the housing by the second adhesive component, the connection strength between the display module and the housing is ensured. Furthermore, the first adhesive component and the second adhesive component are spaced apart from each other along an entire perimeter of the second adhesive component. Accordingly, this makes it easier for the display module to offset the dimensional tolerances, in the front-and-back direction, of elements of the display device. Consequently, the condition in which the display module is supported by the first adhesive component and the second adhesive component is maintained in a more stable manner. In this manner, the display device according to this aspect is a display device with improved reliability.

A display device according to a second aspect of the present disclosure is the display device according to the first aspect, further including: a spacer that is disposed between the second adhesive component and the housing, in which the central portion is bonded to the spacer by the second adhesive component, and the spacer is fixed to the housing by a fixing component that is attachable to and detachable from the housing.

Accordingly, in the display device according to the above-mentioned second aspect, the central portion of the back surface of the display module is bonded to the spacer by the second adhesive component, and the spacer is fixed to the housing by the fixing component that is attachable to and detachable from the housing. In other words, the spacer that is bonded to the display module can be removed from the housing without damaging the spacer, the housing, or the like. Furthermore, since the peripheral portion of the back surface of the display module and the housing can be connected by using the first adhesive component, which is relatively narrow in width, the peripheral portion of the back surface of the display module can be peeled off from the housing. Accordingly, the display module can be more easily removed from the housing. As a result, this makes the display module and the housing, for example, reusable, repairable, and so on.

A display device according to a third aspect of the present disclosure is the display device according to the first aspect or the second aspect, in which the peripheral portion is located further forward than the central portion in the front-and-back direction, the housing includes: a housing body that is connected to the central portion via the second adhesive component; and a side wall that protrudes forward from the housing body, and the first adhesive component connects the peripheral portion and the housing by bonding the peripheral portion and a bonding surface of the side wall, the bonding surface facing forward.

Accordingly, in the display device according to the above-mentioned third aspect, the display module is provided with a stepped structure in which the peripheral portion is disposed further forward than the central portion in the front-and-back direction. Furthermore, the housing includes the side wall that protrudes forward from the peripheral portion of the housing body in a manner that corresponds to the stepped structure. Consequently, even in a case where adhesive components with identical thicknesses were to be used as the first adhesive component and the second adhesive component, each of the first adhesive component and the second adhesive component could be properly used to connect the display module and the housing, for example.

A display device according to a fourth aspect of the present disclosure is the display device according to any one of the first aspect to the third aspect, in which Lmin = E $\times$ T$^2$ is satisfied, where a thickness of the display module is denoted by T for which a unit of measurement is mm; a Young's modulus of the display module is denoted by E for which a unit of measurement is Gpa; and a minimum distance between the first adhesive component and the second adhesive component when viewed in the front-and-back direction is denoted by Lmin for which a unit of measurement is mm.

Accordingly, in display device according to the above-mentioned fourth aspect, minimum distance Lmin (mm) between the second adhesive component and the first adhesive component is properly determined in accordance with the thickness of the display module (width in the front-and-back direction) and the hardness (or softness) of the display module. In other words, even in a case in which a design change is made to the thickness and/or hardness of the display module, the display module and the housing can be properly connected by each of the first adhesive component and the second adhesive component by determining a minimum distance Lmin that is a value that satisfies the above-mentioned conditions.

A display device according to a fifth aspect of the present disclosure is the display device according to any one of the first aspect to the fourth aspect, in which the peripheral portion includes: a first peripheral portion that extends left and right along a top side of the back surface that is rectangular; and a second peripheral portion that extends up and down along a right side or a left side of the back surface, the first adhesive component includes a first component and a second component that are adjacent to each other in a direction in which the peripheral portion extends, and are provided as separate units, the first component bonds an upper edge portion of the second peripheral portion and the first peripheral portion to the housing, and the second component bonds, to the housing, at least a portion of the second peripheral portion that is lower than the upper edge portion of the second peripheral portion.

Accordingly, in the display device according to the above-mentioned fifth aspect, a connecting portion between the first peripheral portion and the second peripheral portion in the peripheral portion of the back surface of the display module, or in other words, an upper corner portion in the peripheral portion is bonded to the housing in a continuous manner by the first component included in the first adhesive component. Accordingly, failures (the entering of foreign substances, such as liquids and the like, for example) that are prone to occur when there is a boundary between the first component and the second component in the upper edge portion of the display module are prevented.

Additional benefits and advantages in one aspect of the present disclosure will become apparent from the specification and the drawings. While such benefits and advantages are yielded by configurations of some embodiments and configurations described in the specification and the drawings, not all configurations are necessary.

Hereinafter, an exemplary embodiment will be specifically described with reference to the drawings. The embodiment described below merely illustrates general or specific examples of the present disclosure. The numerical values, shapes, materials, elements, the arrangement and connection states of the elements, steps, the order of the steps, etc., described in the following embodiment are mere examples, and are therefore not intended to limit the present invention. Accordingly, among elements in the following embodiment, those not appearing in any of the independent claims that indicate the broadest concepts of the present disclosure will be described as optional elements. The figures are schematic diagrams and are not necessarily precise illustrations. In the figures, elements that are essentially the same are given the same reference numbers.

In the following description, the "positive side of the X-axis direction" indicates a direction of the arrow on the X-axis, and "the negative side of the X-axis direction" indicates an opposite direction. "X-axis direction" simply indicates either both the positive side of the X-axis direction and the negative side of the X-axis direction or one or the other of these sides. The same applies to the "Y-axis direction" and the "Z-axis direction". Expressions that indicate relative direction or orientation, such as "parallel", "orthogonal", and the like, also include cases where direction and orientation are not parallel, orthogonal, or the like in a precise sense. "Two directions being parallel to each other" not only refers to a state in which the two directions are completely parallel to each other, but also means that the two directions are substantially parallel to each other, i.e., including an error of approximately several percent.

**(Embodiment)**

[1. Arrangement Example of Display Device 100]

FIG. 1 is a diagram illustrating an example of an arrangement of a plurality of display devices 100 according to the embodiment. In the present embodiment, display device 100 is attached to each of a plurality of seats 2 that are arranged in a cabin of aircraft 1. In other words, display device 100 is attached to the rear of a seat back of seat 2. Display device 100 that is attached to seat 2 faces toward a seat to the rear that is another seat 2 immediately behind seat 2, and is viewed by a passenger seated in the seat to the rear. Such a display device 100 is used by the passenger in the seat to the rear. Display device 100 may be capable of being detached from and attached to seat 2 by the passenger. For example, a passenger seated in a given seat 2 may detach display device 100 that is disposed to the front and may perform handheld operation.

[2. Outline of Configuration of Display Device 100]

FIG. 2 is a perspective view illustrating an appearance of display device 100 according to the embodiment. FIG. 3 is an exploded perspective view of display device 100 according to the embodiment. In the present embodiment, as illustrated in FIG. 2 and FIG. 3, a direction in which display device 100 displays an image is described as the negative side of the Y-axis direction, a left-and-right direction is described as the X-axis direction, and an up-and-down direction is described as the Z-axis direction. In other words, in the following description of the outline of display device 100, "forward" refers to the negative side of the Y-axis direction, and "backward" refers to the positive side of the Y-axis direction, for example. In the present embodiment, "right" and "left" mean "right" and "left" as viewed from the front of display device 100. In other words, hereinafter, "right" refers to the positive side of the X-axis direction, and "left" refers to the negative side of the X-axis direction, for example.

The orientation of display device 100 during use is not particularly limited, and display device 100 may be disposed in a predetermined location so as to display an image downward, diagonally downward, upward, or diagonally upward.

As illustrated in FIG. 2 and FIG. 3, display device 100 according to the embodiment includes display module 101, housing 150, first adhesive component 210, and second adhesive components 250. Display module 101 includes display panel 120 that displays an image on a front surface of display panel 120. More specifically, display module 101 according to the embodiment further includes touch panel 110 that is light transmissive and is disposed in front of display panel 120. Touch panel 110 includes first front surface 114 that faces forward and first back surface 115 that faces backward. Display panel 120 includes second front surface 124 that faces forward and second back surface 125 that faces backward.

Touch panel 110 includes a front surface panel that forms first front surface 114 and a sensor panel that detects contact by a person's finger by a predetermined method, such as an electrostatic-capacitive method. The front surface panel and the sensor panel are light-transmissive to a certain extent. Accordingly, a person disposed in front of display device 100 can view, through touch panel 110, an image displayed on display panel 120 that is disposed so as to oppose first back surface 115 of touch panel 110. In the present embodiment, the front surface panel is, for example, a tabular component made of a transparent resin, such as acrylic resin or the like. The sensor panel is, for example, a component on which a plurality of electrodes, for detecting a location that has been touched on a base material made of resin, are disposed.

A detection result of touch panel 110 is transmitted, via electrical wires not illustrated in the drawings, to a control circuit (not illustrated in the drawings) that controls image display of display panel 120. The control circuit can control display of an image in display panel 120 in accordance with the detection result.

An organic electroluminescent (EL) display panel, for example, is used as display panel 120 that is included in display module 101 according to the present embodiment. In the present embodiment, second front surface 124 of display panel 120 is bonded to first back surface 115 of touch panel 110 by adhesive component 140. Adhesive component 140 is, for example, a transparent adhesive that is referred to as optical clear resin (OCR).

Housing 150 is a component that holds display module 101, and is, for example, made of metal, such as aluminum, aluminum alloy, or the like. Housing 150 includes housing body 153, which opposes second back surface 125 of display panel 120, and side walls 151 that protrude forward from peripheral edges of housing body 153. In the present embodiment, housing body 153 of housing 150 has a configuration (bolt holes or the like) in which housing 150 is connected to seat 2 of aircraft 1 (see FIG. 1) or a fixing component that is interposed between seat 2 and housing 150, for example. Accordingly, display device 100 is attached to seat 2 directly or via the fixing component. The material that housing 150 is made of is not limited to metal, and housing 150 may be fabricated, for example, by resin molding.

In display device 100 configured in this manner, display module 101 is attached to housing 150 by using first adhesive component 210 and second adhesive components 250 that are disposed spaced apart from each other when viewed from a front-and-back direction. First adhesive component 210 and second adhesive components 250 are double-sided adhesive sheets (also referred to as "double-sided tape") that each include an adhesive layer on both sides of a sheet-like base material, for example. Hereinafter, an assembly structure for housing 150 of display module 101 in display device 100 will be described with reference to FIG. 4 through FIG. 6.

[3. Regarding Assembly Structure for Housing 150 of Display 101]

FIG. 4 is a cross-sectional view of an assembly structure for housing 150 of display module 101 according to the embodiment. FIG. 4 schematically illustrates a portion of a cross section of display device 100 that is parallel to plane YZ and passes through line IV-IV in FIG. 2. In FIG. 4, for the sake of simplicity, touch panel 110 is illustrated as a single structure that includes the front surface panel and the sensor panel as a single unit. FIG. 5A is a rear view (view from the positive side of the Y-axis direction) of a configuration of back surface 105 of display module 101 according to the embodiment. FIG. 5B is a front view (view from the negative side of the Y-axis direction) of an example of a layout of first adhesive component 210 and second adhesive components 250 according to the embodiment. In FIG. 5B, an outline of touch panel 110 is represented by a dashed line that forms a rectangle, and an outline of display panel 120 is represented by a two-dot chain line that forms a rectangle. In FIG. 5A and FIG. 5B, center line C in a left-and-right direction of display module 101 is represented by a two-dot chain line that extends in the Z-axis direction. FIG. 6 is an enlarged, exploded perspective view illustrating a portion of first adhesive component 210 according to the embodiment.

As illustrated in FIG. 4, display panel 120, which is an organic EL display panel in the embodiment, includes glass substrates 121 and organic EL element 126. More specifically, display panel 120 includes a pair of glass substrates 121, which oppose each other in the front-and-back direction, and organic EL element 126 that is disposed between the pair of glass substrates 121. When differentiating between the pair of glass substrates 121, the glass substrate 121 in front is referred to as glass substrate 121a, and the glass substrate 121 in back is referred to as glass substrate 121b. Glass substrate 121a is a color filter (CF) substrate that is a glass substrate that forms a color filter, for example. Second front surface 124 of display panel 120 is formed by a front surface of glass substrate 121a (surface toward the negative side of the Y-axis direction). Glass substrate 121b is a thin-film transistor (TFT) substrate that is a glass substrate on which various elements, such as gate electrodes and the like are layered, for example. Second back surface 125 of display panel 120 is formed by a back surface of glass substrate 121b (surface toward the positive side of the Y-axis direction). Organic EL element 126 is a light-emitting portion that includes an anode that is a lower electrode, an EL layer that is a light-emitting layer made of organic materials, and a cathode that is a transparent upper electrode.

Touch panel 110 is disposed on second front surface 124 of display panel 120 having the above-mentioned configuration, via adhesive component 140, which is an OCR, for example. As illustrated in FIG. 5A, back surface 105 of display module 101 configured in this manner includes peripheral portion 106 that includes edges of display module 101 and central portion 108 that is a region located inward of peripheral portion 106. Specifically, as illustrated in FIG. 4 through FIG. 6, when viewing display module 101 in the front-and-back direction, the size of touch panel 110 is larger than the size of display panel 120. In other words, when viewed from the rear (positive side of the Y-axis direction), an outer rim portion of touch panel 110 protrudes outward from display panel 120. In the present embodiment, a region that is located outward of display panel 120 and inward of touch panel 110, when display module 101 is viewed from behind, is referred to as peripheral portion 106 (hereinafter also simply referred to as "peripheral portion 106" or "peripheral portion 106 of display module 101") of back surface 105 of display module 101. In other words, a portion that is located outward of display panel 120 of first back surface 115 of touch panel 110 is treated as being equivalent to peripheral portion 106 of back surface 105 of display module 101. A width of peripheral portion 106 (length in the Z-axis direction in FIG. 4) in a direction orthogonal to the front-and-back direction and a direction in which peripheral portion 106 extends is, for example, no less than 0.5 mm and no more than 5 mm.

Furthermore, a region in which display panel 120 is disposed, when display module 101 is viewed from behind, is referred to as central portion 108 (hereinafter also simply referred to as "central portion 108" or "central portion 108 of display module 101") of back surface 105 of display module 101. In other words, an entirety of second back surface 125 of display panel 120 is treated as being equivalent to central portion 108 of back surface 105 of display module 101.

Note that when display module 101 does not include touch panel 110, the entirety of second back surface 125 of display panel 120 is treated as being equivalent to "back surface 105 of display module 101", and a peripheral portion that includes edges of second back surface 125 is treated as being equivalent to "peripheral portion 106 of display module 101". In other words, second back surface 125 that is back surface 105 of display module 101 is divided into peripheral portion 106 and central portion 108 that is located inward of peripheral portion 106.

In this manner, first adhesive component 210 and second adhesive components 250 are disposed in different regions relative to display module 101 that includes back surface 105 that is divided into two regions (peripheral portion 106 and central portion 108). Specifically, first adhesive component 210 connects peripheral portion 106 of display module 101 and housing 150. Second adhesive component 250 connects central portion 108 of display module 101 and housing 150.

More specifically, as illustrated in FIG. 4, first adhesive component 210 directly connects peripheral portion 106 of display module 101 and housing 150. In other words, first adhesive component 210 connects peripheral portion 106 of display module 101 and housing 150 by bonding together peripheral portion 106 of display module 101 and housing 150. In the present embodiment, first adhesive component 210 is disposed in a rectangular-ring-shaped arrangement along peripheral portion 106 of display module 101. In other words, first adhesive component 210 is disposed to fill the space between peripheral portion 106 of display module 101 and housing 150. First adhesive component 210 is implemented as a component that is highly flexible, such as double-sided tape or the like. Accordingly, when compared to a case in which peripheral portion 106 of display module 101 and housing 150 are connected via a component with high rigidity, such as a component referred to as a bracket, a frame, or the like, for example, it is possible to more easily fill the space between peripheral portion 106 and housing 150. This contributes to improving the reliability of display device 100.

As illustrated in FIG. 5A and FIG. 5B, peripheral portion 106 of display module 101 includes first peripheral portion 106a, which extends left and right along a top side of back surface 105 that is rectangular, and second peripheral portions 106b, which extend up and down along a right side and a left side of back surface 105. In the present embodiment, peripheral portion 106 includes a pair of second peripheral portions 106b on the left and the right. In other words, peripheral portion 106 includes second peripheral portion 106b, which extends along the left side (side toward the negative side of the X-axis direction) of back surface 105, and second peripheral portion 106b, which extends along the right side (side toward the positive side of the X-axis direction) of back surface 105. Peripheral portion 106 further includes third peripheral portion 106c that extends left and right along a bottom side of back surface 105 that is rectangular. In other words, in the present embodiment, rectangular-ring-shaped peripheral portion 106 includes first peripheral portion 106a, a pair of second peripheral portions 106b, and third peripheral portion 106c.

In relation to peripheral portion 106 that is configured as described above, first adhesive component 210 includes first components 211 and second components 220, which are adjacent to each other in directions in which peripheral portion 106 extends, and provided as separate units. As illustrated in FIG. 5B and FIG. 6, first component 211 bonds an upper edge portion of second peripheral portion 106b and first peripheral portion 106a to housing 150. In other words, first component 211 is provided with L-shaped portions that each include a portion that extends in the left-and-right direction (X-axis direction) along first peripheral portion 106a and a portion that extends in the up-and-down direction (Z-axis direction) along second peripheral portion 106b. Second component 220 bonds, to housing 150, at least a portion that is lower than the upper edge portion of second peripheral portion 106b.

More specifically, first adhesive component 210 includes a top-and-bottom pair of first components 211 and a left-and-right pair of second components 220. The lower first component 211 is provided with L-shaped portions that each include a portion that extends in the left-and-right direction (X-axis direction) along third peripheral portion 106c and a portion that extends in the up-and-down direction (Z-axis direction) along second peripheral portion 106b. In the present embodiment, the top-and-bottom pair of first components 211 are common components (parts). For example, by preparing the same component (part) as the upper first component 211, and by inverting it by 180 degrees about the X-axis or the Z-axis, it is possible to obtain the same component as the lower first component 211. The left-and-right pair of second components 220 are disposed between the top-and-bottom pair of first components 211 that are configured in this manner. Specifically, as illustrated in FIG. 5B, second components 220 are disposed, with one being located between each of the edges on the left side (edges toward the negative side of the X-axis direction) of the top-and-bottom pair of first components 211 and the other being located between each of the edges on the right side (edges toward the positive side of the X-axis direction) of the top-and-bottom pair of first components 211. Accordingly, a rectangular-ring-shaped first adhesive component 210 is provided along rectangular-ring-shaped peripheral portion 106.

In first adhesive component 210 that extends along peripheral portion 106, spaces S are provided between first components 211 and second components 220. Specifically, when affixing first components 211 and second components 220, which are pieces of double-sided tape, to peripheral portion 106 of display module 101, if an edge of first component 211 and an edge of second component 220 are positioned to overlap each other in the front-and-back direction, this can more easily lead to the formation of a gap (path leading from the outside to the inside of display device 100) between peripheral portion 106 and housing 150 at an overlapping portion. Consequently, when a screen size of display panel 120 is, for example, 19 inches or more, from a design standpoint, the sizes and so on of first components 211 and second components 220 are determined in a manner such that spaces S that are each about 2 mm are provided between first components 211 and second components 220. Accordingly, when first components 211 and second components 220 are affixed to peripheral portion 106, for first components 211 and second components 220, one edge is prevented from being stacked on top of another edge (being positioned to overlap each other in a front-and-back direction).

In a case where there is a space S in an upper edge portion in display module 101, and a liquid, such as a beverage or the like provided to a passenger of aircraft 1 is spilled on display device 100 from above display device 100, this can more easily lead to the liquid entering the interior of the device via space S. In regard to this point, in display device 100 according to the embodiment, as illustrated in FIG. 5B and FIG. 6, spaces S are provided between first components 211 and second components 220 at edges of display module 101 in the left-and-right direction. Accordingly, for example, a liquid can be prevented from entering the interior of display device 100 via spaces S.

Spaces S need not be provided between first components 211 and second components 220. For example, first adhesive component 210 may be a rectangular-ring-shaped adhesive component that is a single unit that includes a top-and-bottom pair of first components 211 and a left-and-right pair of second components 220. However, in this case, since first adhesive component 210 is fabricated by cutting out a central portion of a single rectangular base material (double-sided tape, for example) in a rectangular shape, a large region of a central portion of the base material becomes waste material. Accordingly, the production cost of first adhesive component 210 will increase. This issue becomes particularly noticeable as the screen size of display panel 120 becomes large. In regard to this point, first adhesive component 210 according to the present embodiment includes a plurality of components that are each elongated (pair of first components 211 and pair of second components 220). Consequently, the plurality of components can be efficiently cut out from a single base material. Accordingly, the production cost of first adhesive component 210 is prevented from increasing.

As illustrated in FIG. 3 and FIG. 4, second adhesive component 250 connects central portion 108 of display module 101 and housing 150 via spacer 300. That is to say, second adhesive components 250 are bonded to central portion 108 of display module 101, and are bonded to spacers 300.

Spacers 300 that are attached to central portion 108 of display module 101 by second adhesive components 250 are fixed to housing 150 by fixing components 400 that are attachable to and detachable from housing 150. In the present embodiment, screws are used for fixing components 400. Fixing component 400 includes screw shaft 410 on which a screw thread is provided on an outer circumference thereof. Screw shaft 410 of fixing component 400 penetrates through penetrating hole 154 that is provided in housing body 153 of housing 150, and is screwed into screw hole 310 provided in spacer 300. Housing body 153 includes spacer restricting component 159 (see FIG. 3 and FIG. 4) that restricts backward (positive side of the Y-axis direction) movement of spacer 300 by coming into contact with spacer 300. Accordingly, this determines the position, in the front-and-back direction (Y-axis direction), of each of spacers 300 that are fixed in place by fixing components 400.

In the present embodiment, spacer 300 includes spacer body 301 that is plate shaped and nut 305 that is made of metal. Nut 305 is provided as a single unit with spacer body 301 by insert molding, for example. In other words, screw hole 310 that is included in spacer 300 is provided in nut 305. A surface (surface toward the negative side of the Y-axis direction) of spacer 300 that is facing display module 101 is virtually flat, and second adhesive component 250 is bonded to almost the entirety of the surface. Spacer 300 need not include nut 305. Spacer body 301 may include a screw hole, which is a screw hole with a screw thread groove provided in an inner-circumferential surface of the screw hole, into which screw shaft 410 screws into.

In the present embodiment, as illustrated in FIG. 3, spacer 300 is fixed to housing 150 by six fixing components 400. The total number of fixing components 400 used to fix spacer 300 may be one or more. However, from the standpoint of stably supporting spacer 300 that is plate shaped, the total number of fixing components 400 may be two or more.

As illustrated in FIG. 3 and FIG. 5B, in the present embodiment, two pairs of second adhesive components 250 and spacers 300 are provided between display module 101 and housing 150. The two second adhesive components 250 are disposed so that center line C is interposed between second adhesive components 250, in the left-and-right direction of display module 101, and are provided spaced apart from each other in the left-and-right direction. Spacers 300 are each bonded to one of second adhesive components 250, and the two spacers 300 are fixed to housing 150 by a plurality of fixing components 400 as described above. Accordingly, display module 101 is supported by housing 150 in a well-balanced manner. The total number of pairs of second adhesive components 250 and spacers 300 is not limited to two, and may be one or may be three or more.

In the present embodiment, first adhesive component 210 and second adhesive components 250 are provided at different positions in the front-and-back direction (Y-axis direction). Specifically, as illustrated in FIG. 4, peripheral portion 106 of display module 101 is disposed at a position that is disposed forward (negative side of the Y-axis direction) of central portion 108 of display module 101 in the front-and-back direction (Y-axis direction). Consequently, in the front-and-back direction, first adhesive component 210 is disposed further forward than second adhesive components 250. Housing 150 includes side wall 151 that protrudes forward from housing body 153. Specifically, side wall 151 protrudes forward from an outer edge portion of housing body 153. Side wall 151 includes bonding surface 151a that faces forward. By bonding together peripheral portion 106 and bonding surface 151a of side wall 151, first adhesive component 210 connects peripheral portion 106 and housing 150. Spacer 300 that is bonded to central portion 108 by second adhesive component 250 is fixed to housing body 153 by fixing component 400. In the present embodiment, as illustrated in FIG. 4 and FIG. 6, side wall 151 includes protective wall 151b located outward of bonding surface 151a. Protective wall 151b is disposed to surround peripheral portion 106 of display module 101 when display device 100 is viewed from the front. Accordingly, an edge portion of peripheral portion 106 is protected by protective wall 151b.

In the present embodiment, first adhesive component 210 and second adhesive components 250 are spaced apart from each other when viewed in the front-and-back direction (Y-axis direction). Here, for the sake of argument, we assume a hypothetical case in which first adhesive component 210 and second adhesive components 250 are continuous with each other or placed in close proximity of each other when viewed in the front-and-back direction. In such a case, due to dimensional tolerances related to thicknesses of first adhesive component 210 and second adhesive components 250 and/or dimensional tolerances and the like in the front-and-back direction of housing 150, it becomes difficult to maintain a satisfactory bonding condition for at least one of first adhesive component 210 or second adhesive components 250. Furthermore, dimensional tolerances in the front-and-back direction of display module 101 and spacer 300 may also adversely influence bonding conditions of at least one of first adhesive component 210 and second adhesive components 250. For example, OCR, which is adhesive component 140 that is disposed between touch panel 110 and display panel 120 in display module 101 is a liquid at the point in time when it is applied to one of touch panel 110 or display panel 120. Accordingly, the width (thickness), in the front-and-back direction, of display module 101 after the liquid hardens becomes prone to variation (individual variation).

For example, we assume a case in which display device 100 has been assembled, and where the positions of the front surfaces (surfaces toward the negative side of the Y-axis direction) of second adhesive components 250 in the front-and-back direction are disposed further forward than their intended design position due to dimensional tolerances of second adhesive components 250 and the like. In other words, we assume a case in which the distances (actual distances) between the front surface of first adhesive component 210 and the front surfaces of second adhesive components 250 in the front-and-back direction are shorter than the intended design distance (design distance). In such a case, if first adhesive component 210 and second adhesive components 250 are disposed in close proximity of each other, peripheral portion 106 becomes subjected to a relatively large amount of force in a forward-facing direction due to central portion 108 of display module 101 being pressed forward. As a result, first adhesive component 210 becomes susceptible to peeling off from bonding surface 151a of housing 150 (see FIG. 4) or peripheral portion 106 of display module 101.

A conceivable solution to resolve the above-mentioned issue is to make the distances between first adhesive component 210 and second adhesive components 250 in the front-and-back direction longer. In such a case, even if the actual distances are shorter than the design distance, the difference between the actual distances and the design distance are more easily offset by the warping of display module 101. As a result, the issue of first adhesive component 210 peeling off can conceivably be made less problematic. However, by making the distances between first adhesive component 210 and second adhesive components 250 longer, when viewed in the front-and-back direction, this would result in the sizes (surface areas when viewed in the front-and-back direction) of second adhesive components 250 becoming smaller, for example. This would cause the connection strength between display module 101 and housing 150 to degrade.

The inventor of the present application worked diligently to address the above-mentioned issue in order to discover conditions under which bonding conditions between first adhesive component 210 and second adhesive components 250 are maintained in a satisfactory manner while ensuring connection strength between display module 101 and housing 150.

Specifically, minimum distances, which are the minimum distances between first adhesive component 210 and second adhesive components 250, at which issues related to bonding conditions between first adhesive component 210 and second adhesive components 250 do not occur were measured, when varying the thickness of display module 101 and the Young's modulus of display module 101. The measurement results are illustrated in TABLE 1 as shown below. In TABLE 1 as shown below, the values of each of the fields in the upper-most row indicate thickness T (unit of measurement: mm) of display module 101, and the values of each of the fields in the left-most column indicate Young's modulus E (unit of measurement: Gpa) of display module 101. Specifically, thickness T and Young's modulus E of display module 101 are respectively the thickness and the Young's modulus of a portion in which touch panel 110 and display panel 120 are overlapping each other in display module 101. In TABLE 1 as shown below, the value in the field at which the corresponding row and column intersect with each other indicates minimum distance Lmin (unit of measurement: mm) between first adhesive component 210 and second adhesive components 250 when viewed in the front-and-back direction.

[TABLE 1]

|  | T=1 | T=2 | T=3 | T=4 | T=5 |
|---|---|---|---|---|---|
| E=1 | 1 | 4 | 9 | 16 | 25 |
| E=2 | 2 | 8 | 18 | 32 | 50 |
| E=3 | 3 | 12 | 27 | 48 | 75 |
| E=4 | 4 | 16 | 36 | 64 | 100 |
| E=5 | 5 | 20 | 45 | 80 | 125 |
| E=6 | 6 | 24 | 54 | 96 | 150 |
| E=7 | 7 | 28 | 63 | 112 | 175 |
| E=8 | 8 | 32 | 72 | 128 | 200 |
| E=9 | 9 | 36 | 81 | 144 | 225 |
| E=10 | 10 | 40 | 90 | 160 | 250 |
| E=11 | 11 | 44 | 99 | 176 | 275 |
| E=12 | 12 | 48 | 108 | 192 | 300 |
| E=13 | 13 | 52 | 117 | 208 | 325 |

(continued)

|  | T=1 | T=2 | T=3 | T=4 | T=5 |
|---|---|---|---|---|---|
| E=14 | 14 | 56 | 126 | 224 | 350 |
| E=15 | 15 | 60 | 135 | 240 | 375 |
| E=16 | 16 | 64 | 144 | 256 | 400 |
| E=17 | 17 | 68 | 153 | 272 | 425 |
| E=18 | 18 | 72 | 162 | 288 | 450 |
| E=19 | 19 | 76 | 171 | 301 | 475 |
| E=20 | 20 | 80 | 180 | 320 | 500 |

As illustrated above in TABLE 1, a display module that has a Young's modulus E that is no less than 1 Gpa and no more than 20 Gpa and a thickness T that is no less than 1 mm and no more than 5 mm is used as display module 101 used in display device 100, for example.

For example, when the value of thickness T (unit of measurement: mm) of display module 101 is "3" and the value of Young's modulus E (unit of measurement: Gpa) of display module 101 is "5", the value of minimum distance Lmin (unit of measurement: mm) at which issues related to bonding conditions between first adhesive component 210 and second adhesive components 250 do not occur is "45". To put it simply, according to these results, it can be seen that the harder (Young's modulus E is large) display module 101 is and the larger thickness T of display module 101 is, the larger minimum distance Lmin between first adhesive component 210 and second adhesive components 250, when viewed in the front-and-back direction, needs to be. More specifically, based on these measurement results, one of the conclusions the inventor of the present application was able to arrive at was that when thickness T of display module 101, Young's modulus E of display module 101, and minimum distance Lmin satisfy Equation 1 as shown below, issues related to bonding conditions between first adhesive component 210 and second adhesive components 250 can be eliminated while ensuring connection strength between display module 101 and housing 150.

$$\mathtt{Lmin\ =\ E\ \times\ T^2\ (Equation\ 1)}$$

In the present embodiment, when the distance between first adhesive component 210 and second adhesive components 250, when viewed in the front-and-back direction, is denoted as L, the distance L between first adhesive component 210 and second adhesive components 250 in the up-and-down direction (Z-axis direction) is the minimum distance L (minimum distance Lmin). Consequently, the Lmin value obtained by using the above-mentioned Equation 1 is used as distance L between first adhesive component 210 and second adhesive components 250 in the up-and-down direction. In other words, distance L between first adhesive component 210 and second adhesive components 250 when viewed in the front-and-back direction (unit of measurement: mm) is greater than or equal to $E \times T^2$ (i.e., the product of the value of Young's modulus E (unit of measurement: Gpa) and thickness T (unit of measurement: mm) of display module 101 raised to the power of two) at any location. The above-mentioned Equation 1 may be applied in cases where Young's modulus E of display module 101 is less than 1 Gpa or greater than 20 Gpa. The above-mentioned Equation 1 may be applied in cases where thickness T of display module 101 is less than 1 mm or greater than 5 mm.

The technical characteristics of display device 100 according to the embodiment as configured above are described as follows, for example.

Display device 100 according to the embodiment is a display device for use in aircraft 1. Display device 100 includes display module 101 that includes display panel 120 that displays an image on the front surface of display panel 120, housing 150 that faces back surface 105 of display module 101 and supports display module 101, first adhesive component 210, and second adhesive components 250. First adhesive component 210 connects peripheral portion 106 of back surface 105 and housing 150. Second adhesive component 250 connects housing 150 and central portion 108 that is a region located inward of peripheral portion 106 of back surface 105. First adhesive component 210 and second adhesive components 250 are spaced apart from each other along an entire perimeter of each of second adhesive components 250 when viewed in the front-and-back direction.

In this manner, in display device 100 according to the embodiment, peripheral portion 106 of back surface 105 of display module 101 and housing 150 are connected by first adhesive component 210. Accordingly, foreign substances, such as dust, liquid, and the like are prevented from entering the interior of display module 101 from peripheral portion 106. Furthermore, by connecting central portion 108 of back surface 105 of display module 101 and housing 150 by second adhesive components 250, the connection strength between display module 101 and housing 150 is ensured. Furthermore, first adhesive component 210 and second adhesive components 250 are spaced apart from each other along an entire perimeter of each of second adhesive components 250. Accordingly, this makes it easier for display module 101 to offset the dimensional tolerances, in the front-and-back direction, of elements of display device 100 (first adhesive component 210, second adhesive components 250, housing 150, and the like). Consequently, the condition in which display module 101 is supported by first adhesive component 210 and second adhesive components 250 is maintained in a more stable manner. As a result, this improves resistance to vibration and/or impact of display device 100, for example. In this manner, display device 100 according to this aspect is a display device with improved reliability.

Display device 100 according to the embodiment further includes spacers 300 that are each interposed between one of second adhesive components 250 and housing 150 (see FIG. 3 and FIG. 4). Central portion 108 is bonded to spacers 300 by second adhesive components 250. Spacers 300 are fixed to housing 150 by fixing components 400 that are attachable to and detachable from housing 150.

In this manner, in the present embodiment, central portion 108 of back surface 105 of display module 101 is bonded to spacers 300 by second adhesive components 250, and spacers 300 are fixed to housing 150 by fixing components 400 that are attachable to and detachable from housing 150. In other words, spacers 300 that are bonded to display module 101 can be removed from housing 150 without damaging spacers 300, housing 150, or the like. Furthermore, since peripheral portion 106 of back surface 105 of display module 101 and housing 150 can be connected by using first adhesive component 210, which is relatively narrow in width, peripheral portion 106 of back surface 105 of display module 101 can be peeled off from housing 150. Accordingly, display module 101 can be more easily removed from housing 150. As a result, this makes display module 101 and housing 150, for example, reusable, repairable, and so on.

In display device 100 according to the present embodiment, peripheral portion 106 is disposed further forward than central portion 108 in the front-and-back direction. Housing 150 includes housing body 153, which is connected to central portion 108 via second adhesive components 250, and side walls 151 that protrude forward from housing body 153. First adhesive component 210 connects peripheral portion 106 and housing 150 by bonding peripheral portion 106 and bonding surface 151a that faces toward the front of side wall 151.

In this manner, in the present embodiment, display module 101 is provided with a stepped structure in which peripheral portion 106 is disposed further forward than central portion 108 in the front-and-back direction. Furthermore, housing 150 includes side wall 151 that protrudes forward from a peripheral portion of housing body 153 in a manner that corresponds to this stepped structure. Consequently, even in a case where adhesive components (such as double-sided tape or the like) with identical thicknesses are used as first adhesive component 210 and second adhesive components 250, each of first adhesive component 210 and second adhesive components 250 can be properly used to connect display module 101 and housing 150, for example.

In display device 100 according to the present embodiment, where the thickness of display module 101 is denoted as T (unit of measurement: mm), the Young's modulus of display module 101 is denoted as E (unit of measurement: Gpa), and the minimum distance between first adhesive component 210 and second adhesive components 250 when viewed in the front-and-back direction is denoted as Lmin (unit of measurement: mm), $Lmin = E \times T^2$ is satisfied.

In this manner, in the present embodiment, minimum distance Lmin (mm) between second adhesive components 250 and first adhesive component 210 is properly determined in accordance with the thickness of display module 101 (width in the front-and-back direction) and the hardness (or softness) of display module 101. In other words, even in a case in which a design change is made to the thickness and/or hardness of display module 101, display module 101 and housing 150 can be properly connected by each of first adhesive component 210 and second adhesive components 250 by determining a minimum distance Lmin that is a value that satisfies the above-mentioned conditions.

In display device 100 according to the present embodiment, as illustrated in FIG. 5A and 5B, peripheral portion 106 includes first peripheral portion 106a that extends left and right along a top side of back surface 105 that is rectangular and second peripheral portions 106b that extend up and down along a right side and a left side of back surface 105. First adhesive component 210 includes first components 211 and second components 220. First components 211 and second components 220 are adjacent to each other in directions in which peripheral portion 106 extends, and provided as separate units. First component 211 bonds an upper edge portion of second peripheral portion 106b and first peripheral portion 106a to housing 150. Second component 220 bonds, to housing 150, at least a portion that is lower than the upper edge portion of second peripheral portion 106b.

With this configuration, a connecting portion between first peripheral portion 106a and second peripheral portion 106b in peripheral portion 106 of display module 101, or in other words, an upper corner portion of peripheral portion 106 is bonded to housing 150 in a continuous manner by first component 211 included in first adhesive component 210 (see FIG. 5B and FIG. 6). Accordingly, a failure (the entering of a foreign substance, such as a liquid, for example), which is more prone to occur when there is a boundary (space S in the present embodiment) between one of first components 211 and one of second components 220 in an upper edge portion of display module 101, can be prevented.

Although display device 100 according to the embodiment has been described above, configurations of display device 100 are not limited to the configuration described in the above embodiment. In view of this, variations of configurations of display device 100 will be described with a focus on differences with the above embodiments.

[4. Variations]

FIG. 7 is an exploded perspective view of display device 100a according to a variation of the embodiment. In FIG. 7, illustration of fixing components 400 (see FIG. 4) has been omitted. FIG. 8 is a cross-sectional view of an assembly structure for housing 150 of display module 101 according to the variation of the embodiment. The positions in the cross section in FIG. 8 correspond to the positions in the cross section in FIG. 4.

As illustrated in FIG. 7 and FIG. 8, display device 100a according to the present variation includes metal plate 600 in addition to the elements included in display device 100 according to the foregoing embodiment. Metal plate 600 is a component that is thermally connected to display module 101. More specifically, metal plate 600 according to the present variation includes openings 610 that are located at positions that correspond to second adhesive components 250 and spacers 300. Consequently, metal plate 600 can be placed in close proximity of display module 101 without interfering with second adhesive components 250 and spacers 300 in the front-and-back direction. Accordingly, display module 101 and metal plate 600 can be thermally connected in an efficient manner. Iron, aluminum, aluminum alloys, or the like may be used as a material for metal plate 600. Metal plate 600 has a thickness of about 0.5 mm to 2 mm, for example.

More specifically, in display device 100a according to the present variation, insulating sheet 700 is disposed on a back surface of metal plate 600. Insulating sheet 700 includes openings 710 that are located at positions that correspond to second adhesive components 250 and spacers 300. Accordingly, metal plate 600 can be electrically insulated from housing 150, a cable located toward a back surface of metal plate 600, and the like. During typical operation, metal plate 600 and housing 150 are maintained in a state in which they do not contact each other as illustrated in FIG. 8, for example. However, there are cases where metal plate 600 and housing 150 may come into close proximity of each other due to vibration of the aircraft, impact, a passenger pressing against display module 101, or the like. Consequently, disposing insulating sheet 700 between metal plate 600 and housing 150 is effective in preventing failures that are caused due to conductivity being established between metal plate 600 and housing 150.

Furthermore, in the front-and-back direction, neither insulating sheet 700 nor metal plate 600 is overlapping second adhesive components 250 or spacer 300. Accordingly, increases to the thickness (width in the front-and-back direction) of display device 100a due to the inclusion of insulating sheet 700 and metal plate 600 in display device 100a can be prevented. Display device 100a may include insulating sheet 700 even in a case where metal plate 600 is not provided. In such a case, back surface 105 of display module 101 can be electrically insulated from housing 150, a cable disposed to the rear of back surface 105, and the like.

By being thermally connected to display module 101, metal plate 600 can function as a heat-dissipating plate for display module 101 during use of display device 100a. Accordingly, degradation of display panel 120 due to heat can be inhibited. Metal plate 600 may also function as a reinforcing component that improves the mechanical strength of display device 100a.

As illustrated in FIG. 1, display device 100a is attached to seat 2 in aircraft 1, for example. In other words, display module 101 included in display device 100a is treated as one component included in aircraft 1. Accordingly, in the event that display module 101 catches fire due to some external factor, for example, there is a need that the amount of heat generated (average amount of heat generated during a predetermined period and/or a maximum value or the like of an amount of heat generated over a predetermined period from the onset of combustion) stays at or below a value defined by a predetermined standard. In regard to this point, since display module 101 has a structure in which touch panel 110 and display panel 120 are integrated with each other via adhesive component 140, there are cases where the amount of heat generated during combustion becomes relatively high. In such cases, metal plate 600 that is disposed along display module 101 may function as a component that inhibits the amount of heat generated during combustion. In the present variation, metal plate 600 is disposed to cover a region that spans a range that excludes regions in which second adhesive components 250 and spacers 300 are disposed in back surface 105 of display module 101. Accordingly, a flow of air supplied from back surface 105 of display module 101 can be blocked or inhibited. As a result, combustion of display module 101 can be inhibited, thereby inhibiting the amount of heat generated during combustion. Furthermore, metal plate 600 functions to absorb the heat of display module 101. This also contributes to inhibiting the amount of heat generated during combustion of display module 101.

In cases where the amount of heat generated during combustion of display module 101 is at or below a value defined by a predetermined standard or the like, display device 100a need not include metal plate 600. Not including metal plate 600 in display device 100 is, for example, advantageous from the perspective of reducing the weight of display device 100 or the like.

**(Other Embodiments)**

Although a display device according to the present disclosure is described above based on the above-mentioned embodiment and variations of the embodiment, the present disclosure is not limited to the above-mentioned embodiment and variations of the embodiment.

Display panel 120 included in display module 101 may, for example, be a type of display panel that is different from an organic EL display panel. For example, a liquid crystal display (LCD) panel may be used as display panel 120.

First adhesive component 210 need not include first components 211 and second components 220 that are provided as separate units. As described above, first adhesive component 210 may, for example, be a rectangular-ring-shaped component that is continuous along peripheral portion 106. In the present embodiment, although first adhesive component 210 includes four components (a pair of first components 211 and a pair of second components 220), first adhesive component 210 may include five or more components. However, space S between two adjacent components that are arranged along peripheral portion 106 may be located at a position along second peripheral portion 106b that extends up and down, or may be located at a position along third peripheral portion 106c that extends left and right along a bottom side of back surface 105.

First adhesive component 210 need not be disposed across the entirety of peripheral portion 106. For example, when a given portion of peripheral portion 106 of display module 101 is connected to side wall 151 of housing 150 by another component, first adhesive component 210 need only be disposed in a region that spans a range that excludes the given portion of peripheral portion 106.

Second adhesive components 250 may connect display module 101 and housing 150 without being connected via spacers 300. For example, when there is a protrusion that protrudes toward housing 150 on central portion 108 of back surface 105 of display module 101, second adhesive components 250 may bond together the protrusion and housing 150. When housing 150 is a plate-shaped component that does not include side wall 151, first adhesive component 210 may bond together peripheral portion 106 of display module 101 and housing 150, and second adhesive components 250 may bond together central portion 108 of display module 101 and housing 150. In this manner, second adhesive components 250 may directly connect central portion 108 of display module 101 and housing 150.

Display module 101 need not include touch panel 110. It is sufficient so long as display module 101 functions to at least display an image. In other words, among touch panel 110 and display panel 120, display module 101 need only include display panel 120. In place of touch panel 110, display module 101 may include a light-transmissive panel for protecting display panel 120, for example, or may include an optical component that applies some form of an optical effect on an image displayed by display panel 120.

The size and the shape of display device 100, for example, are not limited to the size and the shape illustrated in FIG. 1 and FIG. 2 or the like. Display device 100 may, for example, be of a size or a shape that roughly allows it to be firmly held in one hand by a user. In this case, display device 100 may include a processor for executing various processes for such tasks as displaying images and communicating with other devices, as well as a memory, a battery, and the like. In other words, display device 100 may be implemented as a mobile terminal.

Each of the additional notes on display device 100 according to the above embodiment may be applied to the variations of the embodiment. Forms obtained through various modifications to each of the embodiment and the variations that may be conceived by those skilled in the art, as well as forms realized by combining elements and functions in each of the embodiment and the variations without departing from the essence of the present invention are included within the scope of the present invention. Furthermore, arbitrary combinations of two or more of the claims, from among the plurality of claims described in the claims as originally filed, that are within the bounds of technical feasibility, are also included in the scope of the present invention.

Although the present invention has been described and illustrated in detail, it is clearly understood that the same is by way of example only and is not to be taken by way of limitation, the scope of the present invention being limited only by the terms of the appended claims.

**Industrial Applicability**

The display device according to the present disclosure is applicable to a display device or the like provided in an aircraft, for example.

**Reference Signs List**

| | |
|---|---|
| 1 | aircraft |
| 2 | seat |
| 100, 100a | display device |
| 101 | display module |
| 105 | back surface |
| 106 | peripheral portion |
| 106a | first peripheral portion |

EP 4 745 714 A1

| | |
|---|---|
| 106b | second peripheral portion |
| 106c | third peripheral portion |
| 108 | central portion |
| 110 | touch panel |
| 114 | first front surface |
| 115 | first back surface |
| 120 | display panel |
| 121, 121a, 121b | glass substrate |
| 124 | second front surface |
| 125 | second back surface |
| 126 | organic electroluminescent element |
| 140 | adhesive component |
| 150 | housing |
| 151 | side wall |
| 151a | bonding surface |
| 153 | housing body |
| 154 | penetrating hole |
| 159 | spacer restricting component |
| 210 | first adhesive component |
| 211 | first component |
| 220 | second component |
| 250 | second adhesive component |
| 300 | spacer |
| 301 | spacer body |
| 305 | nut |
| 310 | screw hole |
| 400 | fixing component |
| 410 | screw shaft |
| 600 | metal plate |
| 610, 710 | opening |
| 700 | insulating sheet |

**Claims**

1. A display device for use in an aircraft, the display device comprising:

a display module that includes a display panel that displays an image on a front surface of the display panel;
a housing that faces a back surface of the display module and supports the display module;
a first adhesive component that connects a peripheral portion of the back surface and the housing; and
a second adhesive component that connects the housing and a central portion of the back surface, the central portion being a region located inward of the peripheral portion of the back surface, wherein
the first adhesive component and the second adhesive component are spaced apart from each other along an entire perimeter of the second adhesive component when viewed in a front-and-back direction.

2. The display device according to claim 1, further comprising:

a spacer that is disposed between the second adhesive component and the housing, wherein
the central portion is bonded to the spacer by the second adhesive component, and
the spacer is fixed to the housing by a fixing component that is attachable to and detachable from the housing.

3. The display device according to claim 1 or 2, wherein

the peripheral portion is located further forward than the central portion in the front-and-back direction,
the housing includes:

a housing body that is connected to the central portion via the second adhesive component; and
a side wall that protrudes forward from the housing body, and

14

the first adhesive component connects the peripheral portion and the housing by bonding the peripheral portion and a bonding surface of the side wall, the bonding surface facing forward.

**4.** The display device according to claim 1 or 2, wherein

$$\mathrm{Lmin} = \mathrm{E} \times \mathrm{T}^2 \text{ is satisfied,}$$

where

a thickness of the display module is denoted by T for which a unit of measurement is mm;
a Young's modulus of the display module is denoted by E for which a unit of measurement is Gpa; and
a minimum distance between the first adhesive component and the second adhesive component when viewed in the front-and-back direction is denoted by Lmin for which a unit of measurement is mm.

**5.** The display device according to claim 1 or 2, wherein

the peripheral portion includes:

a first peripheral portion that extends left and right along a top side of the back surface that is rectangular; and
a second peripheral portion that extends up and down along a right side or a left side of the back surface,

the first adhesive component includes a first component and a second component that are adjacent to each other in a direction in which the peripheral portion extends, and are provided as separate units,
the first component bonds an upper edge portion of the second peripheral portion and the first peripheral portion to the housing, and
the second component bonds, to the housing, at least a portion of the second peripheral portion that is lower than the upper edge portion of the second peripheral portion.

# FIG. 1

# FIG. 2

FIG. 3

EP 4 745 714 A1

# FIG. 4

# FIG. 5A

EP 4 745 714 A1

# FIG. 5B

EP 4 745 714 A1

## FIG. 6

## FIG. 7

EP 4 745 714 A1

# FIG. 8

## EUROPEAN SEARCH REPORT

**Application Number**

EP 25 20 9230

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/063707 A1 (ITAYA HIDEKI [JP]) 6 March 2014 (2014-03-06) * figures 1-23 * * paragraph [0004] - paragraph [0016] * * paragraph [0042] - paragraph [0072] * ----- | 1-5 | INV. G06F1/16 G02F1/1333 G02F1/1339 |
| A | US 2015/185537 A1 (YAMASHITA SHUJI [JP] ET AL) 2 July 2015 (2015-07-02) * figures 1-7 * * paragraph [0023] - paragraph [0045] * ----- | 1-5 | |
| A | US 2015/177790 A1 (UTO TAKASHI [JP] ET AL) 25 June 2015 (2015-06-25) * figures 3-6 * * paragraph [0031] - paragraph [0049] * ----- | 1-5 | |
| A | US 2020/026116 A1 (MATSUMOTO SHIGEYUKI [JP]) 23 January 2020 (2020-01-23) * figures 1-4 * * paragraph [0023] * ----- | 1-5 | |
| A | US 2021/263570 A1 (KANG SEUNGGYU [KR] ET AL) 26 August 2021 (2021-08-26) * figures 1, 2 * * paragraph [0023] - paragraph [0081] * ----- | 1-5 | **TECHNICAL FIELDS SEARCHED (IPC)** G06F G02F |

The present search report has been drawn up for all claims

| Place of search | Date of completion of the search | Examiner |
|---|---|---|
| The Hague | 20 February 2026 | Khenak, Nawel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 9230

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2026

| Patent document cited in search report | | Publication date | Patent family member(s) | | Publication date |
|---|---|---|---|---|---|
| US 2014063707 | A1 | 06-03-2014 | CN | 103562825 A | 05-02-2014 |
| | | | JP | 6004347 B2 | 05-10-2016 |
| | | | JP | WO2012164676 A1 | 31-07-2014 |
| | | | US | 2014063707 A1 | 06-03-2014 |
| | | | WO | 2012164676 A1 | 06-12-2012 |
| US 2015185537 | A1 | 02-07-2015 | JP | 6221065 B2 | 01-11-2017 |
| | | | JP | 2015144410 A | 06-08-2015 |
| | | | US | 2015185537 A1 | 02-07-2015 |
| US 2015177790 | A1 | 25-06-2015 | CN | 105874522 A | 17-08-2016 |
| | | | EP | 3086306 A1 | 26-10-2016 |
| | | | JP | WO2015093269 A1 | 16-03-2017 |
| | | | US | 2015177790 A1 | 25-06-2015 |
| | | | WO | 2015093269 A1 | 25-06-2015 |
| US 2020026116 | A1 | 23-01-2020 | CN | 210200207 U | 27-03-2020 |
| | | | JP | 2020012969 A | 23-01-2020 |
| | | | US | 2020026116 A1 | 23-01-2020 |
| US 2021263570 | A1 | 26-08-2021 | EP | 4109540 A1 | 28-12-2022 |
| | | | KR | 20210106774 A | 31-08-2021 |
| | | | US | 2021263570 A1 | 26-08-2021 |
| | | | WO | 2021167150 A1 | 26-08-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012213119 A